# EUROPÄISCHE PATENTSCHRIFT

(11) **EP 2 593 969 B1**
(45) Veröffentlichungstag und Bekanntmachung des Hinweises auf die Patenterteilung: **15.08.2018**
(21) Anmeldenummer: 11738164.0
(22) Anmeldetag: 11.07.2011
(51) Int. Cl.: H01L 31/0224, H01L 31/068, H01L 31/18

(54) **VERFAHREN ZUR HERSTELLUNG EINER PHOTOVOLTAISCHEN SOLARZELLE**
METHOD FOR PRODUCING A PHOTOVOLTAIC SOLAR CELL
PROCÉDÉ DE PRODUCTION D'UNE CELLULE PHOTOVOLTAÏQUE

(30) Priorität: 12.07.2010 DE 102010026960
(43) Veröffentlichungstag der Anmeldung: 22.05.2013
(73) Patentinhaber: Fraunhofer-Gesellschaft zur Förderung der angewandten Forschung e.V., 80686 München (DE)
(72) Erfinder: THAIDIGSMANN, Benjamin, 79104 Freiburg (DE); CLEMENT, Florian, 79102 Freiburg (DE); BIRO, Daniel, 79106 Freiburg (DE); WOLF, Andreas, 79100 Freiburg (DE); PREU, Ralf, 79117 Freiburg (DE)
(74) Vertreter: Lemcke, Brommer & Partner Patentanwälte Partnerschaft mbB
(86) Internationale Anmeldenummer: PCT/EP2011/003451
(87) Internationale Veröffentlichungsnummer: WO 2012/007143

(56) Entgegenhaltungen:
- WO-A1-2009/063754
- WO-A1-2009/067005
- WO-A1-2010/150943
- WO-A2-2006/029250
- JP-A- 2009 130 116
- US-A- 4 838 952
- US-A1- 2005 172 996
- US-A1- 2005 176 164
- TOBIAS FELLMETH ET AL: "19.5% EFFICIENT SCREEN PRINTED CRYSTALLINE SILICON METAL WRAP THROUGH (MWT) SOLAR CELLS FOR CONCENTRATOR (2-25x) APPLICATIONS", AIP CONFERENCE PROCEEDINGS, 1. Januar 2010 (2010-01-01), Seiten 47-52, XP55024307, ISSN: 0094-243X, DOI: 10.1063/1.3509230

## Beschreibung

Die Erfindung betrifft ein Verfahren zur Herstellung einer photovoltaischen Solarzelle gemäß Oberbegriff des Anspruchs 1.

Photovoltaische Solarzellen bestehen typischerweise aus einer Halbleiterstruktur, welche einen Basis- und einen Emitterbereich aufweist, wobei die Halbleiterstruktur typischerweise im Wesentlichen durch ein Halbleitersubstrat, wie beispielsweise ein Siliziumsubstrat, gebildet wird. In die Halbleiterstruktur wird typischerweise über die Vorderseite der Solarzelle Licht eingekoppelt, so dass nach Absorption des eingekoppelten Lichts in der Solarzelle eine Generation von Elektron-Lochpaaren stattfindet. Zwischen Basis und Emitterbereich bildet sich ein pn-Übergang aus, an dem die generierten Ladungsträgerpaare getrennt werden. Weiterhin umfasst eine Solarzelle einen metallischen Emitter- sowie einen metallischen Basiskontakt, die jeweils elektrisch leitend mit dem Emitter bzw. mit der Basis verbunden sind. Über diese metallischen Kontakte können die am pn-Übergang getrennten Ladungsträger abgeführt und somit einem externen Stromkreis bzw. einer benachbarten Solarzelle bei Modulverschaltung zugeführt werden.

Es sind unterschiedliche Solarzellenstrukturen bekannt, wobei sich die vorliegende Erfindung auf solche Solarzellenstrukturen bezieht, bei denen beide elektrische Kontakte der Solarzelle auf der Rückseite angeordnet sind, wobei die Basis der Solarzelle über eine rückseitig angeordnete metallische Basiskontaktstruktur und der Emitter der Solarzelle über eine rückseitig angeordnete metallische Rückseitenkontaktstruktur elektrisch kontaktierbar ist. Dies steht im Gegensatz zu Standardsolarzellen, bei denen typischerweise der metallische Emitterkontakt auf der Vorderseite und der metallische Basiskontakt auf der Rückseite der Solarzelle liegt.

Die Erfindung bezieht sich hierbei auf ein Verfahren zur Herstellung einer speziellen Ausgestaltung einer rückseitig kontaktierbaren Solarzelle, der metal-wrap-through-Solarzelle (MWT-Solarzelle). Diese aus EP 985233 und van Kerschaver et al. "A novel silicon solar cell structure with both external polarity contacts on the back surface" Proceedings of the 2nd World Conference on Photovoltaic Energy Conversion, Vienna, Austria, 1998 bekannte Solarzelle weist zwar eine an der zur Lichteinkopplung ausgebildeten Vorderseite der Solarzelle angeordnete metallische Vorderseitenkontaktstruktur auf, die mit dem Emitterbereich elektrisch leitend verbunden ist. Weiterhin weist die Solarzelle jedoch eine Vielzahl sich von der Vorder- zur Rückseite erstreckender Ausnehmungen im Halbleitersubstrat auf, die von metallischen Durchleitungsstrukturen durchdrungen sind und rückseitig mit einer oder mehreren metallischen Rückseitenkontaktstrukturen elektrisch leitend verbunden sind, so dass rückseitig über die Rückseitenkontaktstruktur, die Durchleitungsstruktur und die Vorderseitenkontaktstruktur der Emitterbereich elektrisch kontaktierbar ist.

Die MWT-Struktur weist den Vorteil auf, dass die Ladungsträger aus dem Emitter an der Vorderseite über die Vorderseitenkontaktstruktur eingesammelt werden und somit keine ohmschen Verluste durch einen etwaigen Ladungsträgertransport innerhalb des Halbleitersubstrates von der Vorder- zur Rückseite bezüglich des Emitterbereiches entstehen. Weiterhin ergibt sich durch die rückseitige Kontaktierbarkeit sowohl des Basis- als auch des Emitterbereiches eine einfachere Verschaltung der MWT-Solarzellen im Modul verglichen mit Standardsolarzellen.

Nachteilig an der MWT-Struktur ist, dass verglichen mit Standardsolarzellen, zusätzliche Strukturen, wie beispielsweise die Ausnehmungen und die metallischen Durchleitungsstrukturen durch die Ausnehmungen hindurch erzeugt werden müssen, so dass eine höhere Komplexität und damit höhere Kosten verglichen mit der Herstellung von Standardsolarzellen vorliegen. Darüber hinaus bestehen insbesondere bei ungenauer Prozessierung an den Wänden der Ausnehmungen sowie in dem Bereich, in dem die Rückseitenkontaktstrukturen die Rückseite der Solarzelle bedecken, Risiken zur Ausbildung zusätzlicher Verlustmechanismen, insbesondere können Kurzschlussströme auftreten, sofern die Rückseitenkontaktstruktur fehlerhafterweise in den Basisbereich des Halbleitersubstrates vordringt (so genanntes "Spiking") wodurch sich der Wirkungsgrad der Solarzelle erheblich verringert.

Aus diesem Grund wird in der EP 0 985 233 vorgeschlagen, den Emitter durch die Ausnehmungen hindurch und an der Rückseite zumindest über die von der Rückseitenkontaktstruktur bedeckten Bereiche hinauszuführen, so dass die Rückseitenkontaktstruktur, die der externen Kontaktierung des Emitters dient, keinen Bereich des Halbleitersubstrates der Basisdotierung bedeckt.

Dies erfordert jedoch eine aufwändige Prozessierung und mehrere kostenintensive Maskierungsschritte. Weitere Verfahren zur Herstellung einer photovoltaischen Solarzelle sind in den WO2009/067005 A1, US2005/0172996 A1 und US2005/0176164 A1 bekannt. WO2009/067005 A1 offenbart ein Verfahren gemäß dem Oberbegriff des Anspruchs 1.

Der Erfindung liegt daher die Aufgabe zugrunde, ein Verfahren zur Herstellung solch einer Solarzelle zu schaffen, das zur Implementierung in industrielle Produktionslinien geeignet und insbesondere kostengünstiger gegenüber den vorbekannten Verfahren ist.

Gelöst ist diese Aufgabe durch ein Verfahren gemäß Anspruch 1. Vorteilhafte Ausgestaltungen des Verfahrens finden sich in den Ansprüchen 2 bis 8. Die durch das erfindungsgemäße Verfahren hergestellte photovoltaische Solarzelle weist eine zur Lichteinkopplung ausgebildete Vorderseite auf und umfasst ein Halbleitersubstrat eines Basisdotierungstyps, mindestens einen an der Vorderseite ausgebildeten Emitterbereich eines Emitterdotierungstyps, der dem Basisdotierungstyp entgegengesetzt ist. Dotierungstypen sind hierbei die n-Dotierung und die hierzu entgegengesetzte p-Dotierung.

Die Solarzelle umfasst weiterhin mindestens eine auf der Vorderseite zur Stromeinsammlung ausgebildete metallische Vorderseitenkontaktstruktur, die mit dem Emitterbereich elektrisch leitend verbunden ist, mindestens eine metallische Basiskontaktstruktur, welche an der Rückseite der Solarzelle angeordnet und mit dem Halbleitersubstrat in einem Bereich des Basisdotierungstyps elektrisch leitend verbunden ist, mindestens eine sich von der Vorder- zu der Rückseite erstreckende Ausnehmung in dem Halbleitersubstrat und mindestens eine metallische Durchleitungsstruktur, wobei die Durchleitungsstruktur in der Ausnehmung von der Vorder- zu der Rückseite des Halbleitersubstrates geführt und mit der Vorderseitenkontaktstruktur elektrisch leitend verbunden ist sowie mindestens eine metallische Rückseitenkontaktstruktur, welche an der Rückseite angeordnet und mit der Durchleitungsstruktur elektrisch leitend verbunden ist.

Hinsichtlich dieses Grundaufbaus entspricht die Solarzelle somit der vorbekannten MWT-Struktur. Wesentlich ist, dass bei der Solarzelle in dem Halbleitersubstrat an den Wänden der Ausnehmung ein sich von der Vorder- zur Rückseite erstreckender Durchleitungsemitterbereich ausgebildet ist. Weiterhin ist auf der Rückseite des Halbleitersubstrates, gegebenenfalls auf weiteren Zwischenschichten, eine elektrisch isolierende Isolierungsschicht angeordnet, welche die Rückseite bedeckt. Die Rückseitenkontaktstruktur ist auf der Isolierungsschicht, gegebenenfalls auf weiteren Zwischenschichten angeordnet, so dass die Rückseitenkontaktstruktur durch die Isolierungsschicht gegenüber dem unter der Isolierungsschicht liegenden Halbleitersubstrat elektrisch isoliert ist.

Die Solarzelle weist somit erstmals eine MWT-Struktur auf, bei der einerseits an den Wänden der Ausnehmung ein sich von der Vorder- zur Rückseite erstreckender Durchleitungsemitterbereich ausgebildet ist, bei der jedoch die dem Emitter zugeordnete Rückseitenkontaktstruktur keinen unmittelbaren Kontakt zu dem Halbleitersubstrat aufweist, sondern lediglich über die metallische Durchleitungsstruktur mit der vorderseitig angeordneten metallischen Vorderseitenkontaktstruktur und über diese mit dem Emitterbereich an der Vorderseite elektrisch leitend verbunden ist. Gemäß Erkenntnis des Anmelders ist die genannte Solarzelle in überraschenderweise mit lediglich sehr geringen Restrisiken hinsichtlich der einleitend genannten Verlustmechanismen herstellbar und somit wird eine kostengünstige Implementierung des grundlegenden MWT-Konzepts in die industrielle Fertigung ermöglicht.

Die Solarzelle ist vorzugsweise mittels eines erfindungsgemäßen Verfahrens bzw. einer vorzugsweisen Ausführungsform hiervon hergestellt.

Das erfindungsgemäße Verfahren zur Herstellung einer photovoltaischen Solarzelle mit einer zur Lichteinkopplung ausgebildeten Vorderseite wird im Anspruch 1 definiert. In einem Verfahrensschritt A wird eine Mehrzahl von Ausnehmungen in einem Halbleitersubstrat eines Basisdotierungstyps erzeugt.

In einem Verfahrensschritt B werden ein oder mehrere Emitterbereiche eines Emitterdotierungstyps zumindest an der Vorderseite des Halbleitersubstrates erzeugt, wobei der Emitterdotierungstyp entgegengesetzt zu dem Basisdotierungstyp ist.

In einem Verfahrensschritt C wird auf der Rückseite des Hableitersubstrates eine elektrisch isolierende Isolierungsschicht aufgebracht und in einem Verfahrensschritt D werden metallische Durchleitungsstrukturen in den Ausnehmungen erzeugt. Weiterhin wird in Verfahrensschritt D mindestens eine metallische Basiskontaktstruktur an der Rückseite der Solarzelle erzeugt, welche elektrisch leitend mit dem Halbleitersubstrat in einem Basisdotierbereich ausgebildet wird. Weiterhin wird in Verfahrensschritt D mindestens eine metallische Vorderseitenkontaktstruktur an der Vorderseite der Solarzelle erzeugt, welche elektrisch leitend mit dem Emitterbereich an der Vorderseite des Halbleitersubstrates ausgebildet wird und es wird mindestens eine Rückseitenkontaktstruktur an der Rückseite der Solarzelle erzeugt, welche mit der Durchleitungskontaktstruktur elektrisch leitend verbunden ausgebildet wird.

Diese Verfahrensschritte sind auch bei der Herstellung vorbekannter MWT-Strukturen bekannt. Außerdem wird in Verfahrensschritt B zusätzlich in dem Halbleitersubstrat an den Wänden der Ausnehmungen jeweils ein sich von der Vorder- zur Rückseite erstreckender Durchleitungsemitterbereich des Emitterdotierungstyps ausgebildet und in Verfahrensschritt C die Isolierungsschicht die Rückseite des Halbleitersubstrates, gegebenenfalls weitere zwischenliegende Zwischenschichten bedeckend aufgebracht. Weiterhin wird in Verfahrensschritt D die Rückseitenkontaktstruktur auf die Isolierungsschicht, gegebenenfalls auf weitere Zwischenschichten aufgebracht, so dass die Rückseitenkontaktstruktur Bereiche des Halbleitersubstrates mit Basisdotierung überdeckt und in diesen Bereichen aufgrund der dazwischen liegenden Isolierungsschicht eine elektrische Isolierung zwischen Rückseitenkontaktstruktur und Halbleitersubstrat ausgebildet wird. Weiterhin wird in Verfahrensschritt D die Basiskontaktstruktur auf die Isolierungsschicht, gegebenenfalls auf weitere Zwischenschichten aufgebracht, derart, dass die Basiskontaktstruktur die Isolierungsschicht zumindest bereichsweise durchdringt und eine elektrisch leitende Verbindung zwischen Basiskontaktstruktur und Halbleitersubstrat erzeugt wird. Die Verbindung wird in einem Bereich des Halbleitersubstrates mit Basisdotierung ausgebildet.

Dadurch, dass bei dem erfindungsgemäßen Verfahren an der Rückseite kein Emitterbereich ausgebildet werden muss, wird eine erhebliche Vereinfachung des Herstellungsverfahrens und damit eine Kostenreduzierung erzielt.

Die Erfindung ist weiterhin in der Erkenntnis des Anmelders begründet, dass mit bekannten Verfahren in einfacher Weise Isolierungsschichten herstellbar sind, derart, dass eine auf die Isolierungsschicht aufgebrachte metallische Rückseitenkontaktstruktur zwar Bereiche des Halbleitersubstrates mit Basisdotierung überdeckt, von diesem jedoch durch die Isolierungsstruktur elektrisch isoliert ist und insbesondere keinerlei "Spiking", d. h. fehlerhaftes Durchdringen der Isolierungsschicht durch die Rückseitenkontaktstruktur auftritt und somit keine Wirkungsgradverluste durch hierdurch begründeter Kurzschlussströme auftreten. Das erfindungsgemäße Verfahren überwindet somit weiterhin das bisher herrschende Vorurteil, dass ein hohes Risiko bestehe, dass metallische Kontaktstrukturen eine Isolierungsschicht durchdringen und dadurch Kurzschlussströme verursachen.

Weiterhin wird das Risiko von Kurzschlüssen zwischen Bereichen des Halbleitersubstrates mit Basisdotierung und der dem Emitter zugehörigen Rückseitenkontaktstruktur durch den Einsatz von Metallisierungsverfahren, die die Isolationsschicht nicht angreifen und keinen Kontakt zum Halbleitersubstrat ausbilden, verringert. Vorzugsweise wird daher zur Erzeugung der Rückseitenkontaktstruktur Siebdruck unter Verwendung spezieller Druckpasten, die die Isolationsschicht nicht angreifen und keinen Kontakt zum Halbleitersubstrat ausbilden, eingesetzt. Insbesondere vorteilhaft ist hierfür die Verwendung von Siebdruckpasten, die keine Glasfritte enthalten.

Weiterhin umgeht das erfindungsgemäße Verfahren Risiken durch Kurzschlüsse zwischen Durchmetallisierung und Halbleitersubstrat in den Ausnehmungen dadurch, dass an den Wänden der Ausnehmungen ebenfalls Emitterbereiche ausgebildet werden und es somit im Funktionsprinzip der Solarzelle liegt, dass die Durchleitungsstrukturen elektrisch leitend mit den Wänden der Ausnehmungen und den daran angrenzenden Durchleitungsemitterbereichen verbunden sein können, ohne Kurzschlussströme zu verursachen. Insbesondere kann damit auf die bei vorbekannten MWT-Strukturen notwendigen Isolierungsschichten an den Wänden der Ausnehmungen, welche nur mittels aufwändiger Prozessschritte herstellbar sind und häufig Fehlerquellen durch Löcher aufweisen, verzichtet werden. Das erfindungsgemäße Verfahren stellt somit eine Optimierung der MWT-Struktur hinsichtlich einer kostengünstigen industriellen Fertigung und der Vermeidung von Wirkungsgradverlusten insbesondere aufgrund von Kurzschlussströmen dar. Durch die Isolationsschicht auf der Rückseite besteht zudem die Möglichkeit, die Kontaktfläche zwischen Basiskontaktstruktur und Halbleitersubstrat zu verringern und somit zumindest teilweise eine Oberflächenpassivierung und eine Verbesserung der internen Reflexion zu erzielen. Dies führt zu geringeren Rekombinationsströmen beziehungsweise höheren Ladungsträgergenerationsraten und damit zu höheren Wirkungsgraden im Vergleich zu einer großflächigen Kontaktierung des Halbleitersubstrats. Im erfindungsgemäßen Verfahren wird an der Rückseite des Halbleitersubstrates angrenzend an die Ausnehmung kein sich parallel zur Rückseite erstreckender Emitterbereich ausgebildet.

Im Stand der Technik überdeckte der an der Rückseite ausgebildete Emitterbereich zumindest den Bereich der Rückseite, an dem die Rückseitenkontaktstruktur ausgebildet wird. Im erfindungsgemäßen Verfahren ist jedoch kein solcher rückseitiger Emitterbereich ausgebildet, so dass sich die metallische Rückseitenkontaktstruktur über Bereiche des Halbleitersubstrates erstreckt, die eine Basisdotierung aufweisen, von diesem jedoch durch die zwischenliegende Isolierungsschicht elektrisch isoliert ist.

Die Solarzelle weist daher an der Rückseite einen Bereich auf, in dem die Rückseitenkontaktstruktur von der zwischenliegenden Isolierungsschicht elektrisch von dem basisdotierten Halbleitersubstrat isoliert wird. Entsprechend ist das erfindungsgemäße Verfahren derart ausgebildet, dass sich nach Fertigstellung der Solarzelle eine derartige Schichtstruktur ergibt. Vorzugsweise erstrecken sich mindestens 30 %, weiter bevorzugt mindestens 50 %, insbesondere mindestens 70 % der Rückseitenkontaktstruktur über Bereiche des Halbleitersubstrates mit Basisdotierung und sind von diesem durch die vorgenannte Isolierungsschicht elektrisch isoliert. In dieser vorzugsweisen Ausführungsform überlappen somit mindestens 30 %, bevorzugt mindestens 50 %, insbesondere mindestens 70 % der Fläche der Rückseitenkontaktstruktur an der Rückseite mit basisdotierten Bereichen des Halbleitersubstrates.

Verfahrensschritt B ist derart gestaltet, dass die Ausbildung der Emitterstruktur nur auf der Vorderseite und in den in Verfahrensschritt A erzeugten Ausnehmungen erfolgt. Insbesondere vorteilhaft ist ein einseitiges Aufbringen einer Dotierstoffquelle mittels Aufsprühen, Aufwalzen, Drucken, Aufschleudern oder APCVD- bzw. PECVD-Abscheidung mit anschließendem Aufheizen des Halbleitersubstrats für mindestens 15 min auf mindestens 750 °C, wodurch der Emitter durch Diffusion des Dotierstoffes in das Halbleitersubstrat ausgebildet wird. Vor Verfahrensschritt B, gegebenenfalls unter Zwischenschaltung weiterer Verfahrensschritte wird in einem Verfahrensschritt A0 eine die Rückseite des Halbleitersubstrates bedeckende Diffusionsbarrierenschicht auf die Rückseite des Halbleitersubstrates aufgebracht wird, um eine Diffusion von Dotiermaterial durch die Diffusionsbarrierenschicht hindurch auf das Halbleitersubstrat zu vermeiden. Hierdurch ist in einfacher Weise in Verfahrensschritt B die Ausbildung eines Emitters an der Rückseite vermieden und entsprechend entfällt der Schritt der Emitterabtragung auf der Rückseite.

Verfahrensschritt A0 wird vor Verfahrensschritt A, gegebenenfalls unter Zwischenschaltung weiterer Verfahrensschritte, durchgeführt. Hierdurch werden in Verfahrensschritt A auch Ausnehmungen in der Diffusionsbarrierenschicht erzeugt und es wird somit in einfacher weise eine Diffusionsbarriere erzeugt, die das Eindringen von Dotierstoffen in die Ausnehmungen und somit das Ausbilden der Durchleitungsemitter ermöglicht. Bei Aufbringen der Diffusionsbarrierenschicht in Verfahrensschritt A0 derart, dass sie die Rückseite ganzseitig bedeckt müssen keinerlei kostenintensive Maskierungen oder adäquate Verfahren zur Ausbildung der Emitterbereiche angewendet werden.

Bei der Solarzelle ist vorzugsweise in jeder Ausnehmung der sich von der Vorder- zur Rückseite erstreckende Durchleitungsemitterbereich mit der metallischen Durchleitungsstruktur elektrisch leitend verbunden. Entsprechend wird vorzugsweise in Verfahrensschritt D eine solche elektrisch leitende Verbindung ausgebildet. Hierdurch werden ohmsche Leitungsverluste verringert.

In einer vorzugsweisen Ausführungsform des erfindungsgemäßen Verfahrens wird in Verfahrensschritt D die elektrisch leitende Verbindung zwischen Basiskontaktstruktur und Halbleitersubstrat mittels lokaler Wärmeeinwirkung durch einen Laser erzeugt.

Die Ausbildung lokaler elektrisch leitender Verbindungen zwischen einem Halbleitersubstrat, auf dem eine Isolierungsschicht und darüber liegend eine Metallschicht aufgebracht ist, ist an sich bekannt (so genannte "Laser Fired Contacts", LFC) und in US2004097062 beschrieben. Durch Kombination dieser Technik zur Erzeugung der elektrisch leitenden Verbindung zwischen Rückseitenkontaktstruktur und Basisbereich des Halbleitersubstrates ist eine besonders kostengünstige Realisierung des erfindungsgemäßen Verfahrens möglich.

Insbesondere wird in dieser vorteilhaften Ausgestaltung eine Vereinfachung des Verfahrens erzielt, in dem die Isolierungsschicht ganzflächig auf die Rückseite aufgebracht wird. Hierdurch dient die Isolierungsschicht einerseits als elektrische Isolierung zwischen Rückseitenkontaktstruktur und Halbleitersubstrat sowie zwischen dem überwiegenden Flächenanteil der Basiskontaktstruktur und dem Halbleitersubstrat. Lediglich in den lokalen Bereichen, in denen mittels Lasereinwirkung und kurzzeitigem lokalem Aufschmelzen von Rückseitenkontaktstruktur, Isolierungsschicht und dem angrenzenden Bereich des Halbleitersubstrates eine Schmelzmischung erzeugt wird, ergibt sich in dem erstarrten Schmelzgemisch eine elektrisch leitende Verbindung zwischen Rückseitenkontaktstruktur und Halbleitersubstrat. Die Kombination der ganzflächig aufgebrachten Isolierungsschicht mit der Erzeugung der Basiskontaktierung mittels lokaler Erwärmung durch einen Laser ermöglicht somit eine sehr weitgehende Reduzierung der Prozessschritte und somit eine hohe Kosteneinsparung.

In einer weiteren vorteilhaften Ausführung werden zur Herstellung eines elektrischen Kontakts zwischen Halbleitersubstrat und Basiskontaktstruktur vor Aufbringen der Basiskontaktstruktur kleine Ausnehmungen in der Isolationsschicht erzeugt. An diesen Stellen besteht somit ein direkter Kontakt zwischen Halbleitersubstrat und Basiskontaktstruktur. Die Erzeugung der Ausnehmungen wird vorzugsweise durch Laserablation, Aufbringen von Ätzpasten oder maskiertes Rückätzen erzielt. Das Verfahren der Erzeugung lokaler Ausnehmungen in der Isolationsschicht mit anschließender Ausbildung der Basiskontaktstruktur ist bekannt aus "Silicon Solar Cells on Ultra-Thin Substrates for Large Scale Production", G. Agostinelli et al., 21st EU PVSEC, Dresden, 2006.

Eine besonders vorteilhafte Ausführungsform des erfindungsgemäßen Verfahrens beruht auf dem Einsatz spezieller Pasten in Kombination mit einem Hochtemperaturschritt zur Erzeugung der lokalen Kontakte zwischen Halbleitersubstrat und Basiskontaktstruktur. Vorzugsweise enthält die hierfür eingesetzte Paste Glasfritte, bevorzugt bis zu 10 % Blei- und/oder Bismutborglas, oder reine Blei- bzw. Bismutoxide. In einem Verfahrensschritt Da wird an lokalen Bereichen eine solche Paste aufgebracht, bevorzugt mit einem Flächenanteil von 0,1 % bis 20 %, insbesondere bevorzugt von 0,1 % bis 10 %. In einem Verfahrensschritt Db wird das Halbleitersubstrat stark erhitzt, bevorzugt auf Temperaturen von mindestens 700 °C für eine Zeitdauer von mindestens 5 s. Die Durchführung des Verfahrensschritts Db kann dabei zeitlich vor oder nach der eigentlichen Ausbildung der Basiskontaktstruktur in Schritt D erfolgen. Um die Ausbildung eines besseren lokalen Back-Surface-Fields zu unterstützen, ist die Verwendung einer Paste vorteilhaft, die mit Phosphor oder anderen Elementen, die dem Basisdotierungstyps entsprechen, angereichert ist. Ist die Basisdotierung eine p-Typ Dotierung, sind in der Paste entsprechende Dotierstoffe enthalten, die eine p-Typ Dotierung erlauben. Insbesondere sind vorzugsweise Aluminium, Bor und/oder Gallium enthalten.

Vorzugsweise überdeckt die Basiskontaktstruktur mindestens 30 %, bevorzugt mindestens 50 %, insbesondere mindestens 80 % der Rückseite des Halbleitersubstrates. Vorgenannte Prozentangaben beziehen sich auf Flächenprozent. Um Rekombinationsverluste zu verringern ist es vorteilhaft, dass mindestens 50 %, bevorzugt mindestens 70 %, insbesondere mindestens 90 % der Basiskontaktstruktur durch die Isolationsschicht elektrisch von dem Halbleitersubstrat getrennt sind. Vorgenannte Prozentangaben beziehen sich auf Flächenprozent.

Die Isolierungsschicht ist vorteilhafterweise als dielektrische Schicht ausgebildet. Untersuchungen des Anmelders ergaben, dass insbesondere eine als Schichtsystem aus Aluminiumoxid und Siliziumnitrid ausgebildete Isolierungsschicht, vorzugsweise mit einer Gesamtdicke im Bereich von 70 nm bis 130 nm, bevorzugt etwa 100 nm, für das erfindungsgemäße Verfahren und die erfindungsgemäße Solarzelle geeignet ist. Ebenso liegt es im Rahmen der Erfindung, die Isolierungsschicht als Siliziumoxidschicht, Siliziumnitridschicht, Siliziumcarbidschicht, Titandioxidschicht, Aluminiumoxidschicht, Siliziumreiche Oxinitridschicht oder Mischung der vorgenannten Schichten auszubilden. Vorteilhafterweise weist die Isolierungsschicht eine Dicke im Bereich von 10 nm bis 1 mm, bevorzugt im Bereich von 20 nm bis 100 µm, des Weiteren bevorzugt von 30 nm bis 1 µm, insbesondere bevorzugt von 30 nm bis 300 nm auf. Weiterhin liegt es im Rahmen der Erfindung, die Isolierungsschicht als Schichtstruktur aus mehreren Schichten auszubilden. Hierdurch wird zwar die Prozesskomplexität erhöht, jedoch wird das Risiko eines Durchgreifens der Isolierungsschicht durch Rückseitenkontaktstruktur und damit das Risiko von Kurzschlussströmen in diesem Bereich durch eine Schichtstruktur nahezu ausgeschlossen. Zudem kann eine im Hinblick auf die Rückseitenpassivierung optimierte Schicht mit einer auf größtmögliche Isolationswirkung optimierte Schicht kombiniert werden, wodurch die Effizienz der Solarzelle weiter gesteigert werden kann. Insbesondere ist es vorteilhaft, eine Schicht mit dem Basisdotierungstyp entgegengesetzten Oberflächenladungen einzusetzen, um eine Feldeffektpassivierung der Rückseite auszubilden. Des Weiteren wird die Passivierung der Rückseite durch den Einsatz von Schichten wie beispielsweise thermisch gewachsener Oxidschichten, die eine Absättigung von Oberflächenzuständen erzielen, verbessert.

Eine weitere Vereinfachung und damit Kostenreduzierung des erfindungsgemäßen Verfahrens ergibt sich, weil in Verfahrensschritt A0 die Diffusionsbarrierenschicht zusätzlich als elektrisch isolierende Schicht ausgebildet ist, und die Diffusionsbarrierenschicht in den auf Verfahrensschritt B folgenden Verfahrensschritten nicht entfernt wird. Die Diffusionsbarrierenschicht erfüllt somit zusätzlich die Funktion der elektrischen Isolierung. Insbesondere ist es daher vorteilhaft, in Verfahrensschritt C keine zusätzliche Isolierungsschicht aufzubringen. In dieser vorteilhaften Ausgestaltung des erfindungsgemäßen Verfahrens wird somit in Verfahrensschritt A0 gleichzeitig Verfahrensschritt C ausgeführt und durch ledigliches Aufbringen einer Schicht in Verfahrensschritt A0 ganzflächig auf die Rückseite des Halbleitersubstrates wird die gewünschte Funktion der Diffusionsbarriere sowie der nachfolgenden elektrischen Isolierung gewährleistet und weiterhin ist kein Prozessschritt notwendig, um eine etwaige Entfernung einer Diffusionsbarrierenschicht vorzunehmen. Schichten, mit denen die beschriebenen Anforderungen erfüllt werden, sind beispielsweise Siliziumnitrid, Aluminiumoxid, Titanoxid, Tantaloxid, Siliziumoxid, Siliziumoxinitrid, Mischungen der genannten Substanzen oder Schichtsysteme enthaltend eine oder mehrere dieser Schichten.

Eine weitere Verringerung des Risikos von Kurzschlüssen zwischen Rückseitenkontaktstruktur und Halbleitersubstrat mit Basisdotierung wird durch eine Aufdickung der im vorigen Abschnitt beschriebenen Diffusionsbarrieren- und Isolationsschicht durch mindestens eine zusätzliche Schicht erreicht. Diese Aufdickung findet vorzugsweise vor Verfahrensschritt D statt. Insbesondere kann dafür Siliziumnitrid mit einer Dicke von 10 nm bis 250 nm, vorzugsweise von 30 nm bis 150 nm, des Weiteren bevorzugt von 50 nm bis 130 nm eingesetzt werden.

Untersuchungen des Anmelders haben ergeben, dass insbesondere eine dielektrische Schicht, vorzugsweise eine Siliziumoxidschicht sowohl die Funktion einer Diffusionsbarriere zur Vermeidung einer Diffusion von Dotiermaterial, als auch die Funktion einer elektrischen Isolierung erfüllt. Vorzugsweise weist die Schicht zur Erfüllung beider Funktionen eine Ausgangsdicke im Bereich von 100 nm bis 500 nm, im weiteren bevorzugt im Bereich von 150 nm bis 400 nm auf. Prozessbedingt nimmt die Dicke der dielektrischen Schicht während der auf das Aufbringen der Schicht folgenden Verfahrensschritte ab. Sofern die Diffusionsbarrierenschicht gleichzeitig als Isolationsschicht verwendet wird, gegebenenfalls unter Verwendung einer vor Verfahrensschritt D zusätzlich aufgebrachten Schicht oder einem Schichtsystem, ist bevorzugt eine Gesamtschichtdicke der Isolationsschicht im Bereich von 80 nm bis 400 nm, insbesondere im Bereich von 100 nm bis 250 nm zu verwenden. Besonders vorteilhaft ist die Ausbildung einer Diffusionsbarrierenschicht, die auch die Funktion einer Isolationsschicht erfüllt und gleichzeitig die Rückseite der Solarzelle passiviert. Insbesondere Siliziumoxid kann als Diffusionsbarrierenschicht, Isolationsschicht und Passivierungsschicht eingesetzt werden, gegebenenfalls in Kombination mit einer Siliziumnitridschicht, die eine Schichtdicke im Bereich von 10 nm bis 250 nm, vorzugsweise von 30 nm bis 150 nm, des Weiteren bevorzugt von 50 nm bis 130 nm aufweist. Ebenso liegt es im Rahmen der Erfindung, die Diffusionsbarriere auszubilden als Schicht aus Siliziumnitrid, Aluminiumoxid, Titanoxid, Tantaloxid, Siliziumoxid, Siliziumoxinitrid, Mischungen der genannten Substanzen oder Schichtsysteme enthaltend eine oder mehrere dieser Schichten.

Vorzugsweise wird bei dem erfindungsgemäßen Verfahren die Diffusionsbarriere als Silziumoxidschicht ausgebildet. Insbesondere ist es vorteilhaft, dass die Siliziumschicht einen der folgenden Verfahrensschritte umfassend aufgebracht wird: Einbringen des Halbleitersubstrats in eine Atmosphäre aus Stickstoff, Sauerstoff, Wasser, Dichlorethylen oder anderer Gase oder Mischungen der genannten Stoffe und Erhitzen des Halbleitersubstrats in der vorgenannten Atmosphäre auf Temperaturen von mindestens 700 °C für mindestens 5 min.

Ein einseitiges Aufbringen der Diffusionsbarrierenschicht auf der Rückseite der Halbleiterstruktur mittels dem an sich bekannten Verfahren Plasma Enhanced Chemical Vapour Deposition (PECVD), Atmospheric Pressure Chemical Vapour Deposition (APCVD) oder Kathodenzerstäubung weist den Vorteil auf, dass keine Entfernung der Siliziumdioxidschicht an unerwünschten Bereichen wie beispielsweise der Vorderseite des Halbleitersubstrates notwendig ist. Ebenfalls vorteilhaft ist der Einsatz von Diffusionsbarrieren, die per Druck, Aufsprühen oder Aufschleudern aufgebracht werden, da hierfür industriell kostengünstig implementierbare Verfahren zur Verfügung stehen.

Ein beidseitiges Aufbringen der Siliziumdioxidschicht auf der Vorder- und Rückseite der Halbleiterstruktur als Diffusionsbarrierenschicht und ein anschließendes Entfernen der Siliziumdioxidschicht auf der Vorderseite weist den Vorteil auf, dass kostengünstige Verfahren zur Herstellung der Siliziumdioxidschicht verwendbar sind, insbesondere die an sich bekannte beidseitige Erzeugung der Siliziumdioxidschicht als thermische Siliziumdioxidschicht. Ebenso liegt das beidseitige Aufbringen der Siliziumdioxidschicht oder anderer Schichten wie beispielsweise Siliziumnitrid, Aluminiumoxid, Titanoxid, Tantaloxid, Siliziumoxinitrid, Mischungen der genannten Substanzen oder Schichtsysteme, die als Diffusionsbarrierenschicht verwendet werden können, mittels PECVD, APCVD, Drucken, Aufsprühen oder Abscheiden in einem Tauchbad im Rahmen der Erfindung.

Vorteilhafte Verfahren zur Entfernung der Diffusionsbarriere in unerwünschten Bereichen, zumindest der Vorderseite, sind einseitiges nasschemisches Rückätzen, nasschemisches Rückätzen mit Ätzmaske, Plasmaätzen, Laserablation sowie der Einsatz von Ätzpasten mittels einer Drucktechnik.

Ein einseitiges Aufbringen der Diffusionsbarrierenschicht (Siliziumoxid, Siliziumnitrid, Aluminiumoxid, Titanoxid, Tantaloxid, Siliziumoxinitrid, Mischungen der genannten Substanzen oder Schichtsysteme) mittels einer Drucktechnik auf die Rückseite der Halbleiterstruktur weist ebenfalls den Vorteil auf, dass kein anschließendes Entfernen der Siliziumdioxidschicht auf der Vorderseite notwendig ist. Das Aufbringen mittels Drucktechnik erfolgt vorzugsweise, indem das zur Erzeugung der Diffusionsbarrierenschicht eingesetzte Material auf in eine Trägersubstanz eingebettet wird und anschließend per Inkjet oder Siebdruck auf das Halbleitersubstrat aufgebracht wird. Vorzugsweise erfolgt im Anschluss ein Trocknungsschritt, in dem die Trägersubstanz zumindest teilweise verdampft und die Diffusionsbarrierenschicht stabilisiert wird.

Ein einseitiges Aufbringen der Diffusionsbarrierenschicht mittels Aufsprühen oder Aufwalzen auf die Rückseite der Halbleiterstruktur weist ebenfalls den Vorteil auf, dass keine Entfernung einer Siliziumdioxidschicht auf der Vorderseite notwendig ist. Die Herstellung dielektrischer Schichten mittels Aufsprühen ist an sich bekannt und in "TiO2 antireflection coatings by a low temperature spray process", Hovel, H.J., Journal of the Electrochemical Society, 1978 beschrieben.

Durch die Kombination eines Aufbringens einer Diffusionsbarriere auf der Rückseite des Halbleitersubstrates und dadurch, dass bei der Solarzelle ein Emitterbereich in den Ausnehmungen erwünscht ist, können die Emitterbereiche der erfindungsgemäßen Solarzelle in einfacher Weise hergestellt werden. Vorzugsweise werden in Verfahrensschritt B der Emitterbereich an der Vorderseite und die Durchleitungsemitterbereiche einen der folgenden Verfahrensschritte umfassend erzeugt:
Ein Erzeugen der Emitterbereiche mittels Diffusion nach Abscheiden einer Dotierstoffquelle sowohl an der Vorderseite als auch an den Wänden der Ausnehmungen ermöglicht die Verwendung kostengünstiger Prozessverfahren, insbesondere APCVD, PECVD, Aufsprühen, Drucken, Aufwalzen und Abscheiden in einem Tauchbad zur Abscheiden der Dotierstoffquelle. Besonders vorteilhaft ist die Durchführung der Diffusion in einem Inline-Ofen.

Ebenfalls liegt es im Rahmen der Erfindung, den Emitter auf die Oberfläche der Halbleiterstruktur an der Vorderseite des Halbleitersubstrates sowie an den Wänden der Ausnehmungen durch epitaktisches Aufwachsen einer gegenüber der Basisdotierung entgegengesetzt dotierten Schicht zur erzeugen, wie in "Epitaxy of emitters for crystalline silicon solar cells", Reber, S. et al., Proceedings of the 17th European Photovoltaic Solar Energy Conference, Munich, 2001 beschrieben. Dies weist den Vorteil auf, dass ein Emitter hoher Materialqualität und definierter Dotierstoffkonzentration ausgebildet wird, wodurch die Solarzelleneffizienz gesteigert werden kann.

Weiterhin liegt es im Rahmen der Erfindung, eine Heterostruktur zu erzeugen, bei der der Emitter über eine Schicht abgeschieden wird. Ebenso kann der Emitter auch über Ionenimplantation hergestellt werden.

Die Erzeugung der Ausnehmungen, in denen in weiteren Verfahrensschritten die Durchleitungsstruktur ausgebildet wird, erfolgt vorzugsweise durch Laserablation. Der Vorteil bei der Verwendung von Laserverfahren besteht darin, dass auf bekannte Prozessparameter zurückgegriffen werden kann und sich das Verfahren kostengünstig in industrielle Produktionslinien integrieren lässt.

Weitere vorzugsweise Verfahren zur Erzeugung der Ausnehmungen sind die Verwendung nasschemischer Ätzverfahren oder Plasmaätzverfahren, mechanischer Bohrprozesse und Flüssigkeitsstrahlbohren. In einer vorteilhaften Ausführungsform des Verfahrens wird beim Flüssigkeitsstrahlbohren in den Flüssigkeitsstrahl ein Laser eingekoppelt, wodurch der Bohrprozess beschleunigt wird. Der Flüssigkeitsstrahl kann Dotiermittel enthalten, mit dem die Innenwand der Ausnehmungen während des Bohrprozesses dotiert wird. Dies weist den Vorteil auf, dass der Emitter in Verfahrensschritt B nur einseitig erfolgen muss und die Dotierung der Innenwände der Ausnehmung in Verfahrensschritt A, der in diesem Fall vorzugsweise nach Verfahrensschritt B, im Weiteren bevorzugt nach Verfahrensschritt C ausgeführt wird, gleichzeitig mit der Erzeugung der Ausnehmungen erfolgt.

Die metallischen Strukturen zur Kontaktierung des Emitters, Vorderseitenkontaktstruktur, Durchleitungsstruktur und Rückseitenkontaktstruktur wurden vorangehend mit den genannten drei Begriffen zur Kennzeichnung der örtlichen Anordnung bezeichnet. Es liegt im Rahmen der Erfindung, diese Strukturen mehrstückig auszubilden, ebenso liegt es im Rahmen der Erfindung, lediglich eine einstückige Metallisierungsstruktur auszubilden, welche Vorderseitenkontaktstruktur, Durchleitungsstruktur und Rückseitenkontaktstruktur umfasst.

In einer vorzugsweisen Ausführungsform des erfindungsgemäßen Verfahrens werden Vorderseitenkontaktstruktur, Rückseitenkontaktstruktur und Durchleitungsstruktur mittels Siebdruck ausgebildet. Hierdurch ergibt sich der Vorteil, dass diese Prozesse industriell in einem Inline-Verfahren anwendbar sind und insbesondere die Anwendung des Siebdrucks zur Erzeugung metallischer Strukturen bereits bekannt ist und somit auf vorbekannte Prozessparameter zurückgegriffen werden kann. Hierbei wird Siebdruckpaste verwendet, welche Metallpartikel enthält. Hierbei wird vorzugsweise mittels Siebdruck eine metallhaltige Paste auf die Rückseite des Halbleitersubstrates, gegebenenfalls auf weitere Zwischenschichten, aufgebracht, derart, dass die Paste die Ausnehmungen durchdringt.

Vorteilhafterweise wird die Durchleitungsstruktur derart ausgebildet, dass bei Ausbildung der Durchleitungsstruktur der Durchleitungsemitterbereich nicht oder nur geringfügig geschädigt wird und insbesondere der in Verfahrensschritt B ausgebildete Durchleitungsemitterbereich nicht bei Ausbilden der metallischen Durchleitungsstruktur entfernt wird. Insbesondere ist es hierbei vorteilhaft, die Durchleitungsstruktur durch Verwendung einer silberhaltigen Siebdruckpaste auszubilden.

Um eine ausreichende Durchdringung der Ausnehmungen mit Siebdruckpaste zu gewährleisten, wird bei dem erfindungsgemäßen Verfahren vorzugsweise nach Aufbringen der Siebdruckpaste auf der Vorderseite zwischen Vorder- und Rückseite des Halbleitersubstrates eine Druckdifferenz erzeugt, derart, dass aufgrund der Druckdifferenz die Paste in die Ausnehmungen gedrückt wird. In dieser vorzugsweisen Ausführungsform wird somit aufgrund der Druckdifferenz die Paste von der Rückseite durch die Ausnehmungen hindurch "gesaugt", so dass in einfacher Weise die Erzeugung der metallischen Durchleitungsstrukturen gewährleistet wird.

Besonders Vorteilhaft bei der Ausbildung der Rückseitenkontaktstruktur mittels Siebdruck ist der Einsatz silberhaltiger Pasten, vorzugsweise ohne Zusätze, die die Isolationsschicht auf der Rückseite angreifen, insbesondere ohne Glasfritte. So kann das Risiko eine Kontaktausbildung und damit eines Kurzschlusses zwischen Halbleitersubstrat des Basisdotierungstyps und Rückseitenkontakt weiter verringert werden.

Weitere vorzugsweise Ausführungsformen des erfindungsgemäßen Verfahrens umfassen die Ausbildung von Vorderseitenkontaktstruktur und/oder Rückseitenkontaktstruktur und/oder Durchleitungsstruktur durch galvanische Abscheidung, Dispensen, Aufdampfen, Kathodenzerstäubung oder Druckverfahren wie beispielsweise Inkjet oder Aerosol.

Weitere vorzugsweise Merkmale und Ausführungsformen des erfindungsgemäßen Verfahrens werden im Folgenden anhand der Figuren und der Figurenbeschreibung erläutert. Dabei zeigt:
- Figur 1: eine schematische Darstellung eines Teilausschnitts einer Solarzelle;
- Figur 2: ein Prozessablaufdiagramm eines ersten Ausführungsbeispiels eines erfindungsgemäßen Verfahrens,
- Figur 3: ein Prozessablaufdiagramm eines weiteren Verfahrens und
- Figur 4: ein Prozessablaufdiagramm eines weiteren Verfahrens.
Die Verfahren gemäß Figuren 3 und 4 entsprechen nicht dem Verfahren gemäß der Erfindung.

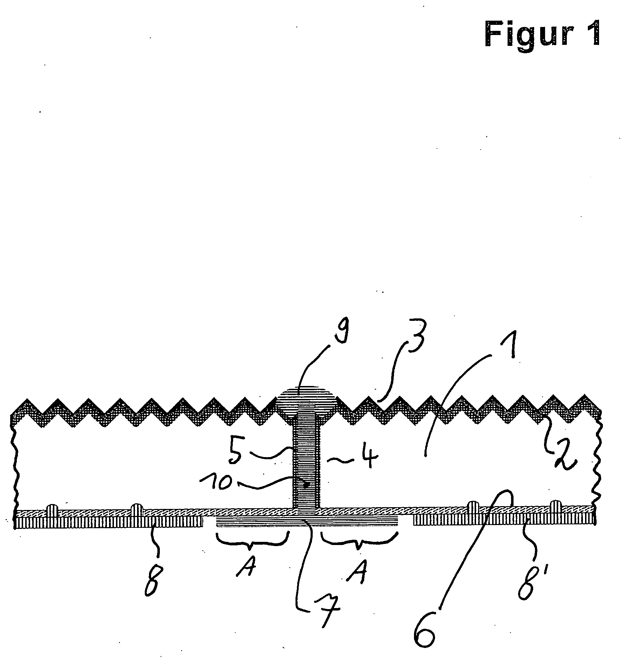

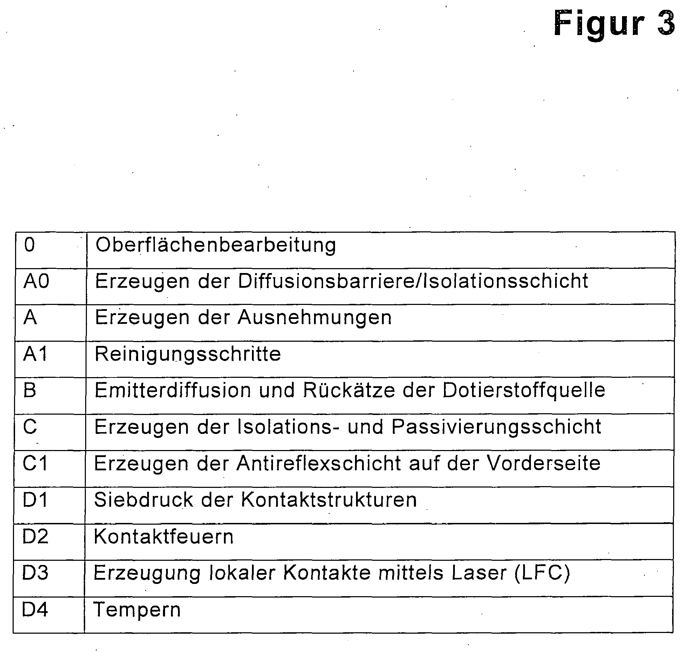

Die in Figur 1 dargestellte Ausführungsbeispiel einer erfindungsgemäßen Solarzelle wurde mittels des in Figur 3 nachfolgend erläuterten Prozesses hergestellt.

Die Solarzelle in Figur 1 umfasst ein p-dotiertes Halbleitersubstrat 1, welches als mono- oder multikristalliner Siliziumwafer mit einem Basiswiderstand von 0,1 Ohm cm bis 10 Ohm cm ausgebildet ist. An der in Figur 1 oben dargestellten Vorderseite ist ein vorderseitiger Emitterbereich 2 ausgebildet. Die Vorderseite weist zur Erhöhung der Lichteinkopplung eine Texturierung auf und zusätzlich ist zur Erhöhung der Lichteinkopplung auf der Vorderseite des Halbleitersubstrates 1 eine als Siliziumnitridschicht ausgebildete Antireflexschicht 3 mit einer Dicke von ca. 70 nm angeordnet.

Figur 1 zeigt lediglich einen Teilausschnitt der erfindungsgemäßen Solarzelle mit lediglich einer Ausnehmung 4. Die Solarzelle setzt sich spiegelbildlich nach rechts und links fort und weist eine Vielzahl von Ausnehmungen auf.

Die Ausnehmung 4 erstreckt sich von der Vorder- zur Rückseite der Solarzelle und ist in etwa zylindrisch ausgebildet.

An den Wänden der Ausnehmung ist ein sich von der Vorderseite zur Rückseite erstreckender Durchleitungsemitterbereich 5 ausgebildet.

Die Rückseite des Halbleitersubstrates 1 ist durch eine als Schichtsystem aus Aluminiumoxid und Siliziumnitrid mit einer Gesamtdicke von 100 nm ausgebildete Isolierungs- und Passivierungsschicht 6 bedeckt. Die Schicht 6 bedeckt die Rückseite des Halbleitersubstrates ganzflächig und ist wiederum sowohl von einer metallischen Rückseitenkontaktstruktur 7 als auch von mehreren metallischen Basiskontaktstrukturen 8, 8' bedeckt, wobei die Basiskontaktstrukturen 8, 8' lokal an einer Vielzahl von punktartigen Kontaktierungsbereichen die Isolierungsschicht 6 durchdringen, so dass ein elektrischer Kontakt zwischen den Basiskontaktstrukturen 8, 8' und dem Halbleitersubstrat 1 im Bereich der Basisdotierung besteht.

An der Vorderseite der Solarzelle gemäß Figur 1 ist eine metallische Vorderseitenkontaktstruktur 9 ausgebildet, welche unmittelbar mit dem Emitterbereich 2 elektrisch leitend verbunden ist, d. h. zwischen Vorderseitenkontaktstruktur 9 und Emitterbereich 2 ist keine Antireflexschicht 3 angeordnet.

Weiterhin ist in der Ausnehmung 4 eine metallische Durchleitungsstruktur 10 ausgebildet.

Vorderseitenkontaktstruktur 9, Durchleitungsstruktur 10 und Rückseitenkontaktstruktur 7 sind einstückig ausgebildet und dementsprechend elektrisch leitend miteinander verbunden.

Wesentlich ist, dass in den in Figur 1 mit A und A' gekennzeichneten Bereichen zwar die Rückseitenkontaktstruktur 7 das Halbleitersubstrat 1 im Bereich der Basisdotierung überdeckt, von diesen jedoch durch die zwischenliegende Isolierungsschicht 6 elektrisch isoliert ist. An der Rückseite des Halbleitersubstrates 1 und insbesondere in den Bereichen A und A' ist kein sich parallel zur Rückseite erstreckender Emitterbereich ausgebildet. Lediglich in dem Bereich, indem der Durchleitungsemitterbereich 5 auf die Rückseite des Halbleitersubstrates 1 auftritt, befindet sich ein vernachlässigbar geringer Bereich der Rückseite, der eine Emitterdotierung aufweist.

Die Vorderseitenkontaktstruktur ist wie bei vorbekannten MWT-Solarzellen ausgebildet, dargestellt beispielsweise in "Processing and comprehensive characterisation of screen-printed mc-si metal wrap through (mwt) solar cells", Clement et al., Proceedings of the 22nd European Photovoltaic Solar Energy Conference, Milan, 2007 .

Die mittels lokaler Erwärmung durch einen Laser erzeugten lokalen elektrisch leitenden Verbindungen (LFC) zwischen Halbleitersubstrat 1 und Basiskontaktstruktur 8, 8' sind in etwa gleichmäßig über die Basiskontaktstruktur verteilt, in etwa punktförmig ausgebildet mit einem Abstand im Bereich von 100 µm bis 1 mm, in diesem Fall von etwa 500 µm. Insgesamt sind etwa 98,5 % der Rückseite des Halbleitersubstrates durch die Isolierungsschicht bedeckt, etwa 1,5 % durch die elektrisch leitenden, punktförmigen Kontakte. Die Solarzelle weist Ausnehmungen mit einem Durchmesser von etwa 100 µm auf, wobei die Ausnehmungen auf Linien angeordnet sind, durchschnittlich wird 1 Loch je 4 cm² Solarzellenfläche ausgebildet.

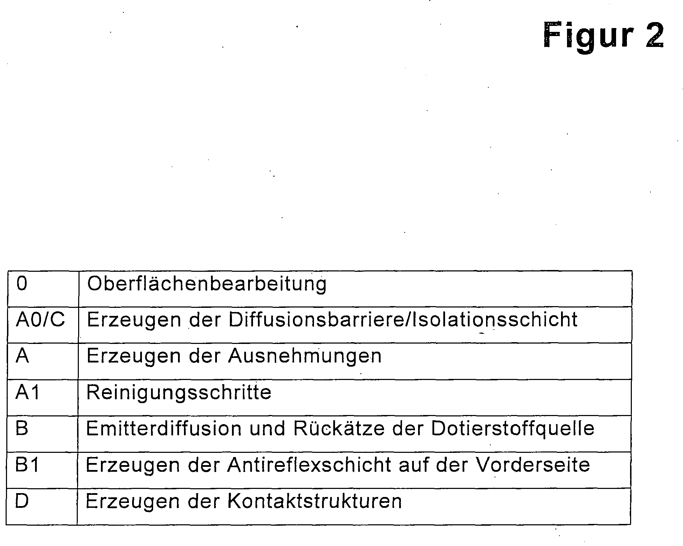

Figur 2 zeigt schematisch ein Ausführungsbeispiel des erfindungsgemäßen Verfahrens. Ein p-dotierter multikristalliner Siliziumwafer mit einem Basiswiderstand von 0,1 Ohm cm bis 10 Ohm cm wird in einem Verfahrensschritt 0 einer Oberflächenbearbeitung unterzogen. Hierbei werden folgende Verfahrensschritte ausgeführt: Entfernen von Oberflächenschäden, die von der Herstellung des Halbleitersubstrats herrühren und Ausbilden einer Texturierung zumindest auf der Vorderseite zur Verbesserung des Lichteinfangs.

Anschließend wird in einem Verfahrensschritt A0/C eine Diffusionsbarriere vollflächig auf der Rückseite des Halbleitersubstrates aufgebracht. Die Diffusionsbarriere ist als Siliziumoxidschicht mit einer Dicke von 250 nm ausgebildet und wird mittels PECVD oder thermischer Oxidation mit anschließender einseitiger Rückätze erzeugt.

In einem Verfahrensschritt A erfolgt anschließend die Erzeugung mehrerer Ausnehmungen, der so genannten "MWT-Löcher". Die Erzeugung der MWT-Löcher erfolgt mittels eines Lasers, wie beispielsweise in "Emitter wrap-through solar cell", Gee et al., Proceedings of the 23rd IEEE Photovoltaic Specialists Conference, Louisville, 1993 beschrieben. Wobei die Löcher an den Positionen des Halbleitersubstrats ausgebildet werden, an denen in den darauffolgenden Verfahrensschritten die Rückseitenkontaktstruktur angeordnet wird.

In einem Verfahrensschritt A1 erfolgt optional anschließend eine Reinigung, in dem das Halbleitersubstrat von eventuellen Verunreinigungen und befreit und Produkte des Lochbohrprozesses entfernt werden. Die Reinigung wird vorzugsweise nasschemisch unter Verwendung ätzender Flüssigkeiten wie Flusssäure, Kalilauge oder anderer Substanzen durchgeführt.

In einem Verfahrensschritt B erfolgt anschließend die Erzeugung des Emitterbereiches an der Vorderseite des Halbleitersubstrates sowie des Durchleitungsemitterbereichs an den Wänden der Ausnehmungen. Dazu wird mittels Abscheidung aus der Gasphase phosphorhaltiges Glas auf dem Halbleitersubstrat abgeschieden und durch Temperatureinwirkung an der Vorderseite sowie an den Wänden der Ausnehmungen, also an den Bereichen, die nicht von der Diffusionsbarrierenschicht bedeckt sind, der Emitter erzeugt. Dazu wird das Halbleitersubstrat für ungefähr 45 min auf eine Temperatur von ungefähr 800 °C bis 900 °C erhitzt.

Das hierbei entstehende Silikatglas wird nachfolgend in einem Ätzschritt mittels eintauchen des Halbleitersubstrats in Flusssäure mit einer Konzentration von ungefähr 10 % für eine Zeitdauer von ca. 1 min entfernt. Die in Verfahrensschritt A0/C aufgebrachte Diffusionsbarriere, welche als Siliziumoxidschicht ausgebildet ist, dient gleichzeitig als Isolierungsschicht und wird daher nicht mehr entfernt.

Verfahrensschritt A0 umfasst somit Verfahrenschritt C in dem in Figur 2 dargestellten Ausführungsbeispiel des erfindungsgemäßen Verfahrens. Lediglich bei Verwendung eines Siebdruckverfahrens mit anschließendem Hochtemperaturschritt zur Ausbildung der Basiskontaktstruktur in Verfahrensschritt D wird die Diffusionsbarrierenschicht noch durch eine Siliziumnitridschicht mit einer Dicke von ca. 60 nm bis 120 nm verstärkt.

In einem Verfahrensschritt B1 wird anschließend eine Antireflexschicht auf die Vorderseite des Halbleitersubstrates zur Verbesserung der Lichteinkopplung aufgebracht, wobei die Antireflexschicht als Siliziumnitridschicht mit einer Dicke von ungefähr 70 nm ausgebildet wird. Ebenfalls kann die Schicht ein Schichtsystem aus anderen Schichten darstellen (Siliziumdioxid, Aluminiumoxid; Siliziumnitrid und andere).

Anschließend erfolgt in einem Verfahrensschritt D die Ausbildung der metallischen Kontaktstrukturen: Durchleitungsstruktur, Rückseitenkontaktstruktur, Basiskontaktstruktur sowie Vorderseitenkontaktstruktur.

Figur 3 zeigt ein anderes Verfahren, wobei gleich gekennzeichnete Prozessschritte analog zu dem Ausführungsbeispiel gemäß Figur 2 ausgeführt werden:
Nach einer Oberflächenbearbeitung in einem Verfahrensschritt 0 erfolgt die ganzflächige Aufbringung der Diffusionsbarriere auf die Rückseite des Halbleitersubstrates in einem Verfahrensschritt A0, das Erzeugen der MWT-Löcher in einem Verfahrensschritt A sowie Reinigungsschritte in einem Verfahrensschritt A1 und die Diffusion der Emitterbereiche aus der Gasphase in einem Verfahrensschritt B.

Im Unterschied zu dem in Figur 2 dargestellten Ausführungsbeispiel und im Gegensatz zum erfindungsgemäßen Verfahren wird in Verfahrensschritt B die Diffusionsbarriere, welche in Verfahrensschritt A0 aufgebracht wurde, jedoch wieder entfernt. Anschließend wird in einem Verfahrensschritt C eine Isolations- und Passivierungsschicht als Schichtsystem aus Aluminiumoxid und Siliziumnitrid ganzflächig auf die Rückseite des Halbleitersubstrates aufgebracht, welche zum einen das Halbleitersubstrat hinsichtlich der Oberflächenrekombinationsgeschwindigkeit passiviert und zum anderen die Funktion als Isolierungsschicht ausübt. Die Gesamtdicke des Schichtsystems beträgt 100 nm, die Schichten werden per PECVD auf der Rückseite des Halbleitersubstrats erzeugt. Dies weist gegenüber dem in Figur 2 dargestellten Ausführungsbeispiel den Vorteil auf, dass die Schicht optimal auf die passivierende und isolierende Eigenschaft hin optimiert ist.

In Verfahrensschritt C1 wird eine Antireflexschicht aufgebracht.

Anschließend werden in den Verfahrensschritten D1 bis D4 die Kontaktstrukturen ausgebildet:
Hierzu werden mittels Siebdruck in einem Verfahrensschritt D1 mittels Aufbringen Metallpartikel enthaltender Paste Vorderseitenkontaktstruktur, Durchleitungsstruktur und Rückseitenkontaktstruktur erzeugt. Die Metallstrukturen werden aus den aufgebrachten Pasten mittels Kontaktfeuern in einem Verfahrensschritt D2 ausgebildet.

In Verfahrensschritt D2 durchdringt jedoch weder die Rückseitenkontaktstruktur noch die Basiskontaktstruktur die in Verfahrensschritt C aufgebrachte Isolierungsschicht. Zur Erzielung der elektrischen Kontaktierung des Basisbereiches des Halbleitersubstrates wird daher in einem Verfahrensschritt D3 mittels lokaler Wärmeeinwirkung mittels eines Lasers nach dem LFC-Prozess eine kurzzeitige lokale Aufschmelzung in punktartigen Bereichen erzielt, so dass der elektrische Kontakt zwischen Basiskontaktstruktur und Halbleitersubstrat im Basisbereich erzielt wird.

In Verfahrensschritt D4 erfolgt ein Tempern bei einer Temperatur von ungefähr 350 °C für eine Zeitdauer von mindestens 30 s, um die Schäden und Verspannungen, die durch den LFC-Prozess entstehen können, auszuheilen.

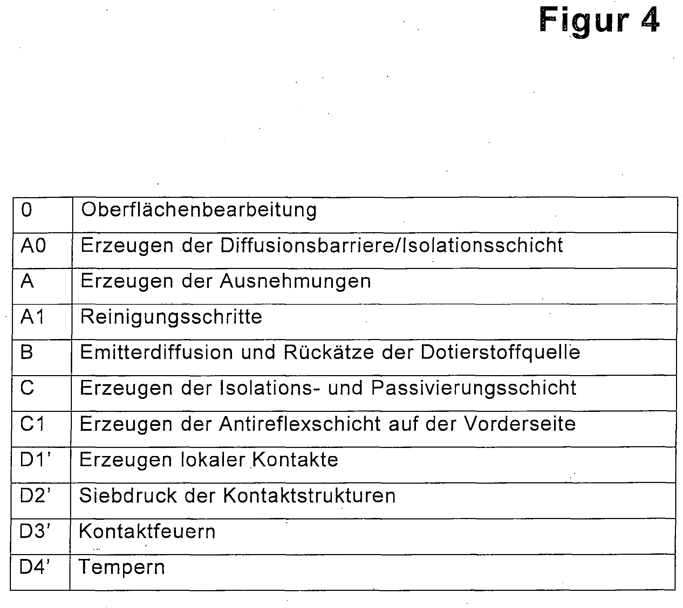

Figur 4 zeigt ein weiteres Verfahren, bei dem gleichbezeichnete Verfahrensschritte denen gemäß Figur 3 und 2 entsprechen.

Die Verfahrensschritte 0, A, A1, B, C und C1 erfolgen wie bei Figur 3 beschrieben.

Anschießend an Verfahrensschritt C1 erfolgt jedoch das Erzeugen der Basiskontaktstruktur wie folgt:
In einem Verfahrensschritt D1' wird mittels Siebdruck lokal an mehreren Bereichen rückseitig auf die Isolierungsschicht Metallpartikel enthaltende Paste aufgebracht. Gegebenenfalls wird die lokal aufgebrachte Paste in einem Temperaturschritt bei einer Temperatur von mindestens 700 °C "durchgefeuert", d. h. während des Temperaturschrittes wird eine die Isolierungsschicht durchdringende Basiskontaktstruktur erzeugt, welche somit mit dem Halbleitersubstrat im Bereich der Basisdotierung elektrisch leitend verbunden ist. Vorzugsweise wird der Kontakt zwischen Halbleitersubstrat und Basiskontaktstruktur durch "durchfeuern" der lokal aufgebrachten Siebdruckpaste allerdings zusammen mit der Kontaktfeuerung der Kontaktstrukturen in Verfahrensschritt D3' erzeugt.

Anschließend erfolgt in einem Verfahrensschritt D2' erneut mittels Siebdruck das Aufbringen von Metallpartikel enthaltender Paste in den Bereichen, in denen Vorderseitenkontaktstruktur, Durchleitüngsstruktur und Rückseitenkontaktstruktur erzeugt werden sollen. Hierbei wird auf die Vorderseite und Rückseite Siebdruckpaste in den Bereichen aufgebracht, in denen die Kontaktstrukturen ausgebildet werden sollen. Die Ausnehmungen werden dabei ebenfalls bedruckt und die Paste durch Erzeugen einer Druckdifferenz zwischen Vorder- und Rückseite in die Ausnehmungen hineingesaugt. Anschließend erfolgt in einem Verfahrensschritt E3' ein Kontaktfeuern, so dass die in den Pasten enthaltenen Metallpartikel untereinander und die Vorderseitenkontaktstruktur mit dem Emitterbereich an der Vorderseite elektrisch leitend verbunden sind, die Rückseitenkontaktstruktur die Isolierungsschicht jedoch nicht durchdringt. Das Kontaktfeuern erfolgt bei einer Temperatur von mindestens 700°C für eine Zeitdauer von mindestens 5 s. Vorzugsweise wird während der genannten Zeitdauer ein Temperaturmaximum von mindestens 730°C erreicht.

In einem Verfahrensschritt D4' erfolgt ein Tempern wie zu Figur 3 beschrieben.

## Patentansprüche

1. Verfahren zur Herstellung einer photovoltaischen Solarzelle mit einer zur Lichteinkopplung ausgebildeten Vorderseite,
folgende Verfahrensschritte umfassend:
A Erzeugen einer Mehrzahl von Ausnehmungen in einem Halbleitersubstrat (1) eines Basisdotierungstyps,
B Erzeugen eines oder mehrerer Emitterbereiche (2) eines Emitterdotierungstyps zumindest an der Vorderseite des Halbleitersubstrates, wobei der Emitterdotierungstyp entgegengesetzt zu dem Basisdotierungstyp ist,
C Aufbringen einer elektrisch isolierenden Isolierungsschicht (6) und
D Erzeugen von metallischen Durchleitungsstrukturen (10) in den Ausnehmungen,
von mindestens einer metallischen Basiskontaktstruktur (8, 8') an der Rückseite der Solarzelle, welche elektrisch leitend mit dem Halbleitersubstrat (1) in einem Basisdotierbereich ausgebildet wird, von mindestens einer metallischen Vorderseitenkontaktstruktur (9) an der Vorderseite der Solarzelle, welche elektrisch leitend mit dem Emitterbereich (2) und der metallischen Durchleitungsstruktur (10) an der Vorderseite des Halbleitersubstrates ausgebildet wird und
von mindestens einer Rückseitenkontaktstruktur (7) an der Rückseite der Solarzelle, welche mit der Durchleitungsstruktur (10) elektrisch leitend verbunden ausgebildet wird,
wobei in Verfahrensschritt B zusätzlich in dem Halbleitersubstrat (1) an den Wänden der Ausnehmungen jeweils ein sich von der Vorder- zur Rückseite erstreckender Durchleitungsemitterbereich (5) des Emitterdotierungstyps ausgebildet wird,
wobei in Verfahrensschritt C die Isolierungsschicht (6) die Rückseite des Halbleitersubstrates, gegebenenfalls weitere zwischenliegende Zwischenschichten, bedeckend aufgebracht wird,
wobei in Verfahrensschritt D
- die Basiskontaktstruktur (8, 8') auf die Isolierungsschicht (6), gegebenenfalls auf weitere Zwischenschichten, aufgebracht wird, derart, dass die Basiskontaktstruktur (8, 8') die Isolierungsschicht (6) zumindest bereichsweise durchdringt, so dass eine elektrisch leitende Verbindung zwischen Basiskontaktstruktur (8, 8') und Halbleitersubstrat (1) erzeugt wird,
wobei an der Rückseite des Halbleitersubstrates angrenzend an die Ausnehmungen kein sich parallel zur Rückseite erstreckender Emitterbereich (2) ausgebildet wird außer in dem Bereich, in dem der Durchleitungsemitterbereich (5) auf die Rückseite des Halbleitersubstrates (1) auftrifft und in Verfahrensschritt D die Rückseitenkontaktstruktur (7) auf die Isolierungsschicht (6), gegebenenfalls auf weitere Zwischenschichten, aufgebracht wird, derart, dass die Rückseitenkontaktstruktur (7) sich über Bereiche des Halbleitersubstrates mit Basisdotierung erstreckt und in diesen Bereichen zumindest aufgrund der dazwischenliegenden Isolierungsschicht (6) eine elektrische Isolierung zwischen Rückseitenkontaktstruktur (7) und Halbleitersubstrat (1) ausgebildet wird,
**dadurch gekennzeichnet,**
**dass** vor Verfahrensschritt B, gegebenenfalls unter Zwischenschaltung weiterer Zwischenschritte, in einem Verfahrensschritt A0 ein Aufbringen einer die Rückseite des Halbleitersubstrates ganzflächig bedeckenden Diffusionsbarrierenschicht erfolgt, zur Vermeidung einer Diffusion von Emitterdotiermaterial durch die Diffusionsbarrierenschicht hindurch und
**dass** Verfahrensschritt A0 vor Verfahrensschritt A, gegebenenfalls unter Zwischenschaltung weiterer Zwischenschritte, durchgeführt wird und dass die Diffusionsbarrierenschicht zusätzlich als elektrisch isolierende Schicht ausgebildet ist und dass die Diffusionsbarrierenschicht in den auf Verfahrensschritt A0 folgenden Verfahrensschritten nicht entfernt wird.

2. Verfahren nach Anspruch 1,
**dadurch gekennzeichnet,**
**dass** in Verfahrensschritt C keine zusätzliche Isolierungsschicht (6) aufgebracht wird.

3. Verfahren nach Anspruch 2,
**dadurch gekennzeichnet,**
**dass** in Verfahrensschritt A0 die Diffusionsbarriere als Siliziumoxidschicht (SiOₓ) ausgebildet ist, vorzugsweise, dass die Siliziumoxidschicht einen der folgenden Verfahrensschritte umfassend aufgebracht wird:
- einseitiges Aufbringen der Siliziumoxidschicht auf der Rückseite der Halbleiterstruktur mittels PECVD oder
- beidseitiges Aufbringen der Siliziumoxidschicht auf der Vorder- und Rückseite der Halbleiterstruktur und anschließendes Entfernen der Siliziumdioxidschicht auf der Vorderseite, wobei vorzugsweise die Siliziumoxidschicht mittels PECVD oder als thermische Siliziumoxidschicht aufgebracht wird oder
- einseitiges Aufbringen der Siliziumoxidschicht mittels einer Drucktechnik auf die Rückseite der Halbleiterstruktur oder
- einseitiges Aufbringen der Siliziumoxidschicht mittels Aufsprühen auf die Rückseite der Halbleiterstruktur.

4. Verfahren nach einem der vorangegangenen Ansprüche,
**dadurch gekennzeichnet,**
**dass** die Isolierungsschicht (6) als dielektrische Schicht ausgebildet ist.

5. Verfahren nach einem der vorangegangenen Ansprüche,
**dadurch gekennzeichnet,**
**dass** in jeder Ausnehmung (4) die Durchleitungsstruktur (10) elektrisch leitend mit dem jeweiligen Durchleitungsemitterbereich (5) ausgebildet wird.

6. Verfahren nach einem der vorangegangenen Ansprüche,
**dadurch gekennzeichnet,**
**dass** in Verfahrensschritt B der Emitterbereich (2) an der Vorderseite und die Durchleitungsemitterbereiche mindestens einen der folgenden Verfahrensschritte umfassend erzeugt werden:
- Erzeugen der Emitterbereiche mittels Diffusion aus der Gasatmosphäre mittels eines Dotierstoff enthaltenden Gases oder
- Erzeugen der Emitterbereiche mittels Diffusion nach Abscheiden einer Dotierstoffquelle oder
- Aufwachsen einer hochdotierten Schicht auf die Oberfläche des Halbleitersubstrates oder
- Erzeugen des Durchleitungsemitterbereichs (5) während der Erzeugung der Ausnehmungen mittels eines flüssigkeitsstrahlgeführten Lasers unter Einsatz einer dotierstoffhaltigen Flüssigkeit.

7. Verfahren nach einem der vorangegangenen Ansprüche,
**dadurch gekennzeichnet,**
**dass** Rückseitenkontaktstruktur (7) und Durchleitungsstruktur (10) einstückig ausgebildet werden, vorzugsweise, dass Vorderseitenkontaktstruktur (9), Rückseitenkontaktstruktur (7) und Durchleitungsstruktur (10) einstückig ausgebildet werden.

8. Verfahren nach Anspruch 7,
**dadurch gekennzeichnet,**
**dass** Vorderseitenkontaktstruktur (9), Rückseitenkontaktstruktur (7) und Durchleitungsstruktur (10) mittels Siebdruck ausgebildet werden, vorzugsweise, dass zur Ausbildung von Vorderseitenkontaktstruktur (9), Rückseitenkontaktstruktur (7) und Durchleitungsstruktur (10) mittels Siebdruck eine metallhaltige Paste auf eine Seite, vorzugsweise auf die Rückseite des Halbleitersubstrates, gegebenenfalls auf weitere Zwischenschichten, aufgebracht wird, derart, dass die Paste die Ausnehmungen durchdringt.

## Claims

1. Method for producing a photovoltaic solar cell comprising a front face designed for coupling-in light, said method comprising the following steps:
A. producing a plurality of cut outs in a base-doping-type semiconductor substrate (1),
B. producing one or more emitter-doping-type emitter regions (2) at least on the front face of the semiconductor substrate, the emitter-doping type being the opposite of the base-doping type,
C. applying an electrically insulating insulation layer (6) and
D. producing metal through-conducting structures (10) in the cut outs, producing at least one metal base contact structure (8, 8') on the rear face of the solar cell, which structure is electrically conductively connected to the semiconductor substrate (1) in a base-doping region, producing at least one metal front-face contact structure (9) on the front face of the solar cell which is electrically conductively connected to the emitter region (2) and the metal through-conducting structure (10) on the front face of the semiconductor substrate, and producing at least one rear-face contact structure (7) on the rear face of the solar cell, which is electrically conductively connected to the through-conducting structure (10),
in method step B, an emitter-doping-type through-conducting emitter region (5), which extends from the front face to the rear face, being additionally formed in each case in the semiconductor substrate (1) on the walls of the cut outs,
in method step C, the insulation layer (6) being applied so as to cover the rear face of the semiconductor substrate, optionally additional intermediate layers,
in method step D
- the base contact structure (8, 8') being applied to the insulation layer (6), optionally to additional intermediate layers, in such a way that the base contact structure (8, 8') penetrates the insulation layer (6) at least in regions, and so an electrically conductive connection is produced between the base contact structure (8, 8') and the semiconductor substrate (1),
an emitter region (2) extending in parallel with the rear face not being formed on the rear face of the semiconductor substrate adjacent to the cut outs, except in the region in which the through-conducting emitter region (5) meets the rear face of the semiconductor substrate (1), and in method step D the rear-face contact structure (7) being applied to the insulation layer (6), optionally to additional intermediate layers, in such a way that the rear-face contact structure (7) extends over regions of the semiconductor substrate having base doping, and in these regions electrical insulation being formed between the rear-face contact structure (7) and the semiconductor substrate (1), at least on account of the insulation layer (6) placed therebetween,
**characterised in that**
prior to method step B, optionally by inserting additional intermediate steps, in a method step A0, a diffusion barrier layer is applied so as to completely cover the rear face of the semiconductor substrate in order to prevent diffusion of emitter-doping material through the diffusion barrier layer, and **in that** method step A0 is carried out prior to method step A, optionally by inserting additional intermediate steps, and **in that** the diffusion barrier layer is additionally formed as an electrically insulating layer, and **in that** the diffusion barrier layer is not removed in the method steps following method step A0.

2. Method according to claim 1, **characterised in that** no additional insulation layer (6) is applied in method step C.

3. Method according to claim 2, **characterised in that** in method step A0, the diffusion barrier is in the form of a silicon oxide (SiOₓ) layer, preferably **in that** the silicon oxide layer is applied in a manner involving one of the following method steps:
- applying the silicon oxide layer to one side on the rear face of the semiconductor structure by means of PECVD or
- applying the silicon oxide layer to both sides on the front face and the rear face of the semiconductor structure and subsequently removing the silicon dioxide layer from the front face, the silicon oxide preferably being applied by means of PECVD or as a thermal silicon oxide layer or
- applying the silicon oxide layer to one side by means of a printing technique on the rear face of the semiconductor structure or
- applying the silicon oxide layer to one side by means of spraying on the rear face of the semiconductor structure.

4. Method according to any of the preceding claims, **characterised in that** the insulation layer (6) is a dielectric layer.

5. Method according to any of the preceding claims, **characterised in that** in each cut out (4), the through-conducting structure (10) is electrically conductively connected to the relevant through-conducting emitter region (5).

6. Method according to any of the preceding claims, **characterised in that** in method step B, the emitter region (2) is produced on the front face and the through-conducting emitter regions are produced in a manner involving at least one of the following method steps:
- producing the emitter regions by means of diffusion from the gas atmosphere by means of a gas containing a doping substance or
- producing the emitter regions by means of diffusion after depositing a doping-substance source or
- growing a highly doped layer on the surface of the semiconductor substrate or
- producing the through-conducting emitter region (5) during the production of the cut outs by means of a liquid-jet-guided laser using a liquid that contains a doping substance.

7. Method according to any of the preceding claims, **characterised in that** the rear-face contact structure (7) and the through-conducting structure (10) are formed in one piece, preferably **in that** the front-face contact structure (9), the rear-face contact structure (7) and the through-conducting structure (10) are formed in one piece.

8. Method according to claim 7, **characterised in that** the front-face contact structure (9), the rear-face contact structure (7) and the through-conducting structure (10) are formed by means of screen printing, preferably **in that** in order to form the front-face contact structure (9), the rear-face contact structure (7) and the through-conducting structure (10) by means of screen printing, a paste that contains metal is applied to one face, preferably to the rear face of the semiconductor substrate, optionally to additional intermediate layers, in such a way that the paste penetrates the cut outs.

## Revendications

1. Procédé de production d'une cellule photovoltaïque avec une face avant conçue pour une transmission de la lumière, comprenant les étapes de procédé suivantes consistant à :
A générer une pluralité d'évidements dans un substrat semi-conducteur (1) d'un type de dopage de base,
B générer une ou plusieurs régions d'émetteur (2) d'un type de dopage d'émetteur au moins sur la face avant du substrat semi-conducteur, où le type de dopage d'émetteur est opposé au type de dopage de base,
C appliquer une couche isolante d'isolation électrique (6) et
D générer des structures traversantes métalliques (10) dans les évidements, au moins une structure de contact de base métallique (8, 8') sur la face arrière de la cellule photovoltaïque, laquelle est formée de manière à assurer un contact électroconducteur avec le substrat semi-conducteur (1) dans une région de dopant de base, au moins une structure de contact de face avant métallique (9) sur la face avant de la cellule photovoltaïque, laquelle est formée de manière à assurer un contact électroconducteur avec la région d'émetteur (2) et la structure traversante métallique (10) sur la face avant du substrat semi-conducteur et au moins une structure de contact de face arrière (7) sur la face arrière de la cellule photovoltaïque, laquelle est reliée de manière électroconductrice à la structure traversante (10),
où à l'étape de procédé B, une région d'émetteur traversante (5) d'un type de dopage d'émetteur s'étendant de l'avant vers l'arrière est en outre formée dans le substrat semi-conducteur (1) sur les parois des évidements respectifs,
où à l'étape de procédé C, la couche isolante (6) est appliquée de sorte à recouvrir la face arrière du substrat semi-conducteur, éventuellement d'autres couches intermédiaires,
où à l'étape de procédé D
- la structure de contact de base (8, 8') est appliquée sur la couche isolante (6), éventuellement sur d'autres couches intermédiaires, de sorte que la structure de contact de base (8, 8') pénètre au moins localement dans la couche isolante (6), de sorte qu'une liaison électroconductrice entre la structure de contact de base (8, 8') et le substrat semi-conducteur (1) est générée,
où sur la face arrière du substrat semi-conducteur dans la région adjacente aux évidements aucune région d'émetteur (2) s'étendant parallèlement à la face arrière n'est formée, excepté dans la région où se trouve la région d'émetteur traversante (5) sur la face arrière du substrat semi-conducteur (1) et à l'étape de procédé D, la structure de contact de face arrière (7) est appliquée sur la couche isolante (6), éventuellement sur d'autres couches intermédiaires, de sorte que la structure de contact de face arrière (7) s'étend sur les régions du substrat semi-conducteur avec dopage de base et dans ces régions au moins sur la couche isolante intermédiaire (6), une isolation électrique entre la structure de contact de face arrière (7) et le substrat semi-conducteur (1) est formée,
**caractérisé en ce que**,
avant l'étape de procédé B, éventuellement avec interposition d'autres étapes intermédiaires, dans une étape de procédé A0, une application d'une couche de barrière de diffusion recouvrant toute la surface de la face arrière du substrat semi-conducteur est obtenue, pour empêcher une diffusion du matériau dopant émetteur à travers la couche de barrière de diffusion et **en ce que** l'étape de procédé A0 est réalisée avant l'étape de procédé A, éventuellement avec interposition d'autres étapes intermédiaires, et **en ce que** la couche de barrière de diffusion est en outre formée à titre de couche électriquement isolante et **en ce que** la couche de barrière de diffusion n'est pas retirée lors des étapes de procédé intervenant après l'étape de procédé A0.

2. Procédé selon la revendication 1,
**caractérisé en ce que**,
à l'étape de procédé C, aucune autre couche isolante (6) n'est appliquée.

3. Procédé selon la revendication 2,
**caractérisé en ce que**,
à l'étape de procédé A0, la barrière de diffusion est réalisée sous la forme d'une couche d'oxyde de silicium, de préférence **en ce que** la couche d'oxyde de silicium est appliquée selon l'une des étapes de procédé suivantes consistant à :
- appliquer d'un seul côté la couche d'oxyde de silicium sur la face arrière de la structure semi-conductrice par dépôt chimique en phase vapeur assisté par plasma (PECVD) ou
- appliquer des deux côtés la couche d'oxyde de silicium sur les faces avant et arrière de la structure semi-conductrice puis retirer la couche d'oxyde de silicium de la face avant, où de préférence la couche d'oxyde de silicium est appliquée par PECVD ou sous forme de couche d'oxyde de silicium thermique ou
- appliquer d'un seul côté la couche d'oxyde de silicium par une technique à pression sur la face arrière de la structure semi-conductrice ou
- appliquer d'un seul côté la couche d'oxyde de silicium par pulvérisation sur la face arrière de la structure semi-conductrice.

4. Procédé selon l'une des revendications précédentes,
**caractérisé en ce que**,
la couche isolante (6) est formée à titre de couche diélectrique.

5. Procédé selon l'une des revendications précédentes,
**caractérisé en ce que**,
dans chaque évidement (4), la structure traversante (10) est formée de sorte à assurer un contact électroconducteur avec chacune des régions d'émetteur traversantes (5).

6. Procédé selon l'une des revendications précédentes,
**caractérisé en ce que**,
à l'étape de procédé B, la région d'émetteur (2) sur la face avant et les régions d'émetteur traversantes sont générées selon au moins l'une des étapes de procédé suivantes consistant à :
- générer les régions d'émetteur par diffusion sous atmosphère gazeuse avec un gaz contenant un dopant ou
- générer les régions d'émetteur par diffusion après élimination d'une source de dopant ou
- agrandir une couche fortement dopée sur la surface supérieure du substrat semi-conducteur ou
- générer la région d'émetteur traversante (5) pendant l'obtention des évidements au moyen d'un laser traversant un liquide après ajout d'un liquide contenant un dopant.

7. Procédé selon l'une des revendications précédentes,
**caractérisé en ce que**,
la structure de contact de face arrière (7) et la structure traversante (10) sont formées en un seul tenant, de préférence **en ce que** la structure de contact de face avant (9), la structure de contact de face arrière (7) et la structure traversante (10) sont formées en un seul tenant.

8. Procédé selon la revendication 7,
**caractérisé en ce que**,
la structure de contact de face avant (9), la structure de contact de face arrière (7) et la structure traversante (10) sont formées par sérigraphie, de préférence **en ce que**, pour la formation de la structure de contact de face avant (9), de la structure de contact de face arrière (7) et de la structure traversante (10) par sérigraphie, une pâte contenant du métal est appliquée sur une face, de préférence sur la face arrière du substrat semi-conducteur, éventuellement sur d'autres couches intermédiaires de sorte que la pâte pénètre dans les évidements.
